# EUROPEAN PATENT APPLICATION

(11) **EP 4 322 210 A1**
(43) Date of publication of application: **14.02.2024**
(21) Application number: 23188405.7
(22) Date of filing: 28.07.2023
(51) Int. Cl.: H01L 23/373, H01L 23/433, H01L 23/538, H01L 25/16, H01L 23/40

(54) **SEMICONDUCTOR MODULE AND METHOD FOR FABRICATING THE SAME**

(30) Priority: 29.07.2022 KR 20220094821
(71) Applicant: LX Semicon Co., Ltd., Daejeon 34027 (KR)
(72) Inventor: KIM, Tae Ryong, 34027 Daejeon (KR); KIM, Deog Soo, 34027 Daejeon (KR)
(74) Representative: 2SPL Patentanwälte PartG mbB

(57) **Abstract**

A semiconductor module according to the present disclosure includes a circuit board having a first surface and a second surface; a first semiconductor device, the first semiconductor device being mounted on the first surface of the circuit board; a second semiconductor device, the second semiconductor device being mounted on the second surface of the circuit board; a first heat dissipation substrate, the first heat dissipation substrate being placed on the top of the first semiconductor device, wherein the first heat dissipation substrate is coupled to a second surface of the first semiconductor device; and a second heat dissipation substrate, the second heat dissipation substrate being placed on the top of the second semiconductor device, wherein the second heat dissipation substrate is coupled to a second surface of the second semiconductor device.

## Description

### CROSS-REFERENCE TO RELATED APPLICATIONS

This application claims the benefit of the Korean Patent Application No. 10-2022-0094821 filed on July 29, 2022, which is hereby incorporated by reference as if fully set forth herein.

### BACKGROUND

### Field of the Invention

The present disclosure relates to a semiconductor module, and more particularly to a semiconductor module having a double-sided heat dissipation structure.

### Discussion of the Related Art

With recent increases in the demand for semiconductors in various fields, a variety of research and development has been conducted to improve semiconductor functions under specific conditions in addition to the main functions of semiconductors.

In general, a semiconductor module may include at least one semiconductor device in one package. In particular, a semiconductor module including a semiconductor device whose physical properties may change due to an increase in the amount of heat generated due to a high withstand voltage and a high current may include a heat dissipation means to dissipate heat. Semiconductor modules including heat dissipation means may be divided into semiconductor modules having a single-sided heat dissipation structure and semiconductor modules having a double-sided heat dissipation structure.

In particular, a semiconductor module having a double-sided heat dissipation structure is known to be advantageous in terms of the effect of heat dissipation because it can emit heat to both upper and lower portions of each semiconductor device.

Such a semiconductor module having a double-sided heat dissipation structure uses a spacer individually for each semiconductor device for the purpose of compensating for thickness deviation between the semiconductor device and a double-sided heat dissipation substrate, forming a space for injection of a molding material, and electrical connection between the semiconductor device and the heat dissipation substrate.

However, in the case where the spacer is used, when the semiconductor device is bonded to the spacer, misalignment may occur, and poor adhesion between the spacer and the double-sided heat dissipation substrate may occur due to the height deviation of each spacer. In addition, since the bonding process between the semiconductor device and the spacer and the bonding process between the spacer and the double-sided heat dissipation substrate are required, there is a problem in that the yield is reduced.

### SUMMARY

An aspect of the present disclosure is to provide a semiconductor module in which a semiconductor device is modularized in a laminated type, and a method for fabricating the same.

Another aspect of the present disclosure is to provide a semiconductor module capable of securing a gap between first and second heat dissipation substrates without using an existing spacer, and a method for manufacturing the same.

Still another aspect of the present disclosure is to provide a semiconductor module capable of electrically connecting electrodes of a semiconductor device to a circuit board on which the semiconductor device is mounted using a conductive clip, and a method for manufacturing the same.

According to an aspect of the present disclosure, there is provided a semiconductor module, including a circuit board having a first surface and a second surface; a first semiconductor device, the first semiconductor device being mounted on the first surface of the circuit board; a second semiconductor device, the second semiconductor device being mounted on the second surface of the circuit board; a first heat dissipation substrate, the first heat dissipation substrate being placed on the top of the first semiconductor device, wherein the first heat dissipation substrate is coupled to a second surface of the first semiconductor device with a second electrode formed thereon; and a second heat dissipation substrate, the second heat dissipation substrate being placed on the top of the second semiconductor device, wherein the second heat dissipation substrate is coupled to a second surface of the second semiconductor device with a second electrode formed thereon.

According to another aspect of the present disclosure, there is provided a method for fabricating a semiconductor module, the method including: placing a circuit board having a first surface and a second surface; mounting a first semiconductor device on the first surface of the circuit board; mounting a second semiconductor device on the second surface of the circuit board; placing a first heat dissipation substrate on the top of the first semiconductor device, wherein the first heat dissipation substrate is coupled to a second surface of the first semiconductor device with a second electrode formed thereon; and placing a second heat dissipation substrate on the top of the second semiconductor device, wherein the second heat dissipation substrate is coupled to a second surface of the second semiconductor device with a second electrode formed thereon.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is a diagram schematically showing the configuration of a semiconductor module having a double-sided heat dissipation structure according to a first embodiment of the present disclosure;
FIG. 2 is a diagram schematically showing the configuration of a semiconductor module having a double-sided heat dissipation structure according to a second embodiment of the present disclosure;
FIG. 3 is a diagram schematically showing the configuration of a semiconductor module having a double-sided heat dissipation structure according to a third embodiment of the present disclosure;
FIGS. 4A and 4B are plan views according to various embodiments of a conductive clip shown in FIG. 1;
FIG. 5 is a schematic circuit diagram showing a power device to which the semiconductor module having a double-sided heat dissipation structure shown in FIGS. 1 to 3 is applied; and
FIGS. 6A to 6E are schematic process cross-sectional views showing a method for fabricating a semiconductor module having a double-sided heat dissipation structure according to one embodiment of the present disclosure.

### DETAILED DESCRIPTION OF THE DISCLOSURE

In the specification, it should be noted that like reference numerals already used to denote like elements in other drawings are used for elements wherever possible. In the following description, when a function and a configuration known to those skilled in the art are irrelevant to the essential configuration of the present disclosure, their detailed descriptions will be omitted. The terms described in the specification should be understood as follows.

Advantages and features of the present disclosure, and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art. Further, the present disclosure is only defined by scopes of claims.

A shape, a size, a ratio, an angle, and a number disclosed in the drawings for describing embodiments of the present disclosure are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted.

In a case where 'comprise', 'have', and 'include' described in the present specification are used, another part may be added unless 'only∼' is used. The terms of a singular form may include plural forms unless referred to the contrary.

In construing an element, the element is construed as including an error range although there is no explicit description.

In describing a time relationship, for example, when the temporal order is described as 'after∼', 'subsequent∼', 'next∼', and 'before∼', a case which is not continuous may be included unless 'just' or 'direct' is used.

It will be understood that, although the terms "first", "second", etc. may be used herein to describe various elements, these elements should not be limited by these terms. These terms are only used to distinguish one element from another. For example, a first element could be termed a second element without departing from the scope of the present disclosure.

The term "at least one" should be understood as including any and all combinations of one or more of the associated listed items. For example, the meaning of "at least one of a first item, a second item, and a third item" denotes the combination of all items proposed from two or more of the first item, the second item, and the third item as well as the first item, the second item, or the third item.

Features of various embodiments of the present disclosure may be partially or overall coupled to or combined with each other, and may be variously inter-operated with each other and driven technically as those skilled in the art can sufficiently understand. The embodiments of the present disclosure may be carried out independently from each other, or may be carried out together in co-dependent relationship.

Hereinafter, embodiments of the present disclosure will be described in detail with reference to the accompanying drawings.

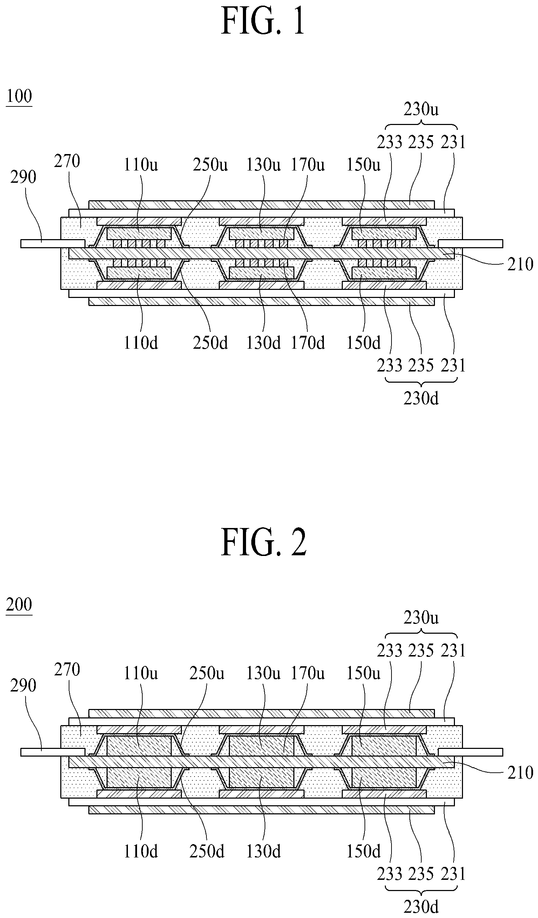

FIG. 1 is a diagram schematically showing the configuration of a semiconductor module having a double-sided heat dissipation structure according to a first embodiment of the present disclosure. As shown in FIG. 1, a semiconductor module 100 having a double-sided heat dissipation structure according to the first embodiment of the present disclosure (hereinafter referred to as a "semiconductor module") includes first semiconductor devices 110u, 130u, and 150u, second semiconductor devices 110d, 130d, and 150d, a circuit board 210, a first bump 170u, a second bump 170d, a first conductive clip 250u, a second conductive clip 250d, a first heat dissipation substrate 230u, a second heat dissipation substrate 230d, and a molding member 270.

The first semiconductor devices 110u to 150u and the second semiconductor devices 110d to 150d refer to semiconductor devices manufactured through a wafer-level process. In one embodiment, a semiconductor constituting the semiconductor devices 110u to 150u and 110d to 150d may include a power semiconductor device or a micro controller unit (MCU) device. The power semiconductor device may perform an operation of converting DC power supplied from a power supply unit such as a battery into AC power for driving a motor through a switching operation and supplying the AC power. The MCU device is a single chip in which a microprocessor and an input/output module are integrated may serve as the brain of various electronic devices.

For example, the first semiconductor devices 110u to 150u and the second semiconductor devices 110d to 150d may include a power semiconductor device such as a gate turn-off thyristor (GTO), an insulated gate bipolar transistor (IGBT), or a metal oxide semiconductor field effect transistor (MOSFET), or a semiconductor device such as a diode.

Although not shown in FIG. 1, a first electrode and a second electrode may be formed on first surfaces of the first semiconductor devices 110u to 150u and the second semiconductor devices 110d to 150d, and a third electrode may be formed on second surfaces of the first semiconductor devices 110u to 150u and the second semiconductor devices 110d to 150d. The first and second electrodes may be a gate electrode and a source electrode, and the third electrode may be a drain electrode. For example, when the semiconductor device includes a power semiconductor device such as a MOSFET, the first electrode may be a gate electrode, the second electrode may be a source electrode, and the third electrode may be a drain electrode. As another example, when the semiconductor device includes a power semiconductor device such as an IGBT, the first electrode may be a gate electrode, the second electrode may be an emitter electrode, and the third electrode may be a collector electrode.

In FIG. 1, the semiconductor module 100 is illustrated as including three first semiconductor devices 110u, 130u, and 150u and three second semiconductor devices 110d, 130d, and 150d, but this is only an example. The number of the first semiconductor devices 110u to 150u and the second semiconductor devices 110d to 150d may be variously changed according to the type of application in which the semiconductor module 100 is used.

The first semiconductor devices 110u, 130u, and 150u may be mounted on a first surface of the circuit board 210, for example, an upper surface thereof, and the second semiconductor devices 110d, 130d, and 150d may be mounted on a second surface of the circuit board 210, for example, a lower surface thereof. At this time, when the first semiconductor devices 110u, 130u, and 150u are mounted on the first surface of a predetermined region of the circuit board 210, the second semiconductor devices 110d, 130d, and 150d may be mounted on the second surface of the same region of the circuit board 210.

In this manner, in the present disclosure, the semiconductor devices 110u to 150d may be mounted on both surfaces of the circuit board 210 in a laminated form, so that the number of mountable semiconductor devices per process unit area increases, thereby reducing the area required to mount the same number of semiconductor devices.

The first semiconductor devices 110u to 150u and the second semiconductor devices 110d to 150d are mounted on the circuit board 210. The circuit board 210 may be a printed circuit board (PCB) in which circuit wirings are printed on both surfaces thereof. A first circuit wiring (not shown) is patterned on the first surface of the circuit board 210, and a second circuit wiring (not shown) is patterned on the second surface of the circuit board 210.

The first semiconductor devices 110u, 130u, and 150u are mounted on the first surface of the circuit board 210 to be electrically connected to the first circuit wiring, and the second semiconductor devices 110d, 130d, and 150d are mounted on the second surface of the circuit board 210 to be electrically connected to the second circuit wiring.

The first semiconductor devices 110u, 130u, and 150u mounted on the first surface of the circuit board 210 and the second semiconductor devices 110d, 130d, and 150d mounted on the second surface of the circuit board 210 may be electrically connected to each other through a conductive path (not shown) formed inside the circuit board 210.

The first bump 170u is configured to electrically connect the first surface of the first semiconductor devices 110u, 130u, and 150u, for example, the lower surface, to the first surface of the circuit board 210. More specifically, the first bump 170u is disposed between the first surface of the first semiconductor devices 110u, 130u, and 150u and the first surface of the circuit board 210 to electrically connect the first and second electrodes formed on the first surface of the first semiconductor devices 110u, 130u, and 150u to the first circuit wiring formed on the first surface of the circuit board.

The second bump 170d is configured to electrically connect the first surface of the second semiconductor devices 110d, 130d, and 150d, for example, the upper surface, to the second surface of the circuit board 210. More specifically, the second bump 170d is disposed between the first surface of the second semiconductor devices 110d, 130d, and 150d and the second surface of the circuit board 210 to electrically connect the first and second electrodes formed on the first surface of the second semiconductor devices 110d, 130d, and 150d to the second circuit wiring (not shown) formed on the second surface of the circuit board 210.

In one embodiment, the first and second bumps 170u and 170d may be made of a copper-based metal. According to this embodiment, the first bump 170u and the second bump 170d may be formed through an electroless plating process, which is known to have relatively accurate thickness control.

For example, when the first semiconductor devices 110u to 150u and the second semiconductor devices 110d to 150d are a flip-chip type semiconductor devices, the semiconductor module 100 may include a plurality of the first bumps 170u and a plurality of the second bumps 170d. In addition, the first semiconductor devices 110u to 150u and the second semiconductor devices 110d to 150d on which the first and second bumps 170u and 170d are formed may be connected to the circuit board 210 through a conductive adhesive member (not shown). For example, the adhesive member may be a Sn-Ag-based adhesive member or an Ag-based adhesive member.

In this case, the first and second electrodes of the first semiconductor devices 110u to 150u and the second semiconductor devices 110d to 150d may be electrically connected to the circuit board 210 through the first and second bumps 170u and 170d formed on a semiconductor device pad portion (not shown) rather than a wire bonding method, so that fine pitch mounting may be possible.

In one embodiment, in order to improve the flatness of the semiconductor module 100, the first and second bumps 170u and 170d may be formed to have different thicknesses according to the thickness of the first semiconductor devices 110u to 150u and the second semiconductor devices 110d to 150d connected to the corresponding bump 170u or 170d and a distance between the first and second heat dissipation substrates 230u and 230d. That is, the bump connected to the thick semiconductor device among the first semiconductor devices 110u to 150u and the second semiconductor devices 110d to 150d is formed to be thinner than the bump connected to the thin semiconductor device, or the bump connected to the thin semiconductor device may be formed to be thicker than the bump connected to the thick semiconductor device.

As described above, in the present disclosure, since the bumps 170u and 170d electrically connecting the semiconductor device to the circuit board 210 replace the existing spacer, the spacer can be removed, thereby preventing the occurrence of a crack due to the spacer. In addition, since the process of forming the spacer can be omitted, the manufacturing process of the semiconductor module can be simplified.

The first conductive clip 250u is disposed between the first semiconductor devices 110u, 130u, and 150u and the first heat dissipation substrate 230u to cover the second surface of the first semiconductor devices 110u, 130u, and 150u. That is, the first conductive clip 250u is coupled to be in surface contact with the second surface of the first semiconductor devices 110u, 130u, and 150u. The second conductive clip 250d is disposed between the second semiconductor devices 110d, 130d, and 150d and the second heat dissipation substrate 230d to cover the second surface of the second semiconductor devices 110d, 130d, and 150d. That is, the second conductive clip 250d is coupled to be in surface contact with the second surface of the second semiconductor devices 110d, 130d, and 150d.

As described above, according to the present disclosure, the first conductive clip 250u is coupled to the second surface of the first semiconductor devices 110u, 130u, and 150u facing the first heat dissipation substrate 230u to ensure surface contact therebetween, and the second conductive clip 250d is coupled to the second surface of the second semiconductor devices 110d, 130d, and 150d facing the second heat dissipation substrate 230d to ensure surface contact therebetween, so that heat generated from the first semiconductor devices 110u, 130u, and 150u and the second semiconductor devices 110d to 150d may be easily transferred to the first and second heat dissipation substrates 230u and 230d. Accordingly, the heat dissipation effect may be maximized.

Meanwhile, the first and second conductive clips 250u and 250d are configured to electrically connect drain electrodes (not shown) formed on the second surfaces of the first semiconductor devices 110u, 130u, and 150u and the second semiconductor devices 110d to 150d to the circuit board 210. To this end, the first and second conductive clips 250u and 250d may contain a copper-based metal or a metal having high electrical conductivity and thermal conductivity.

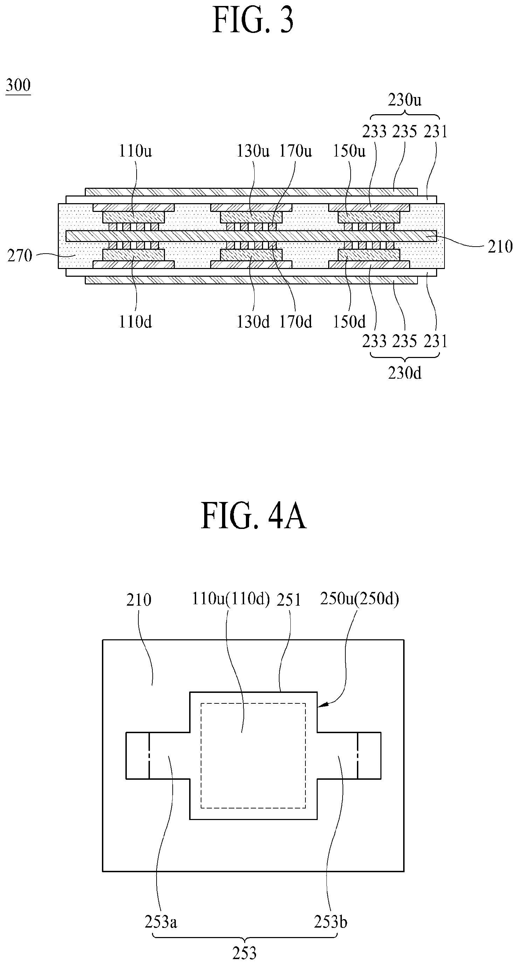

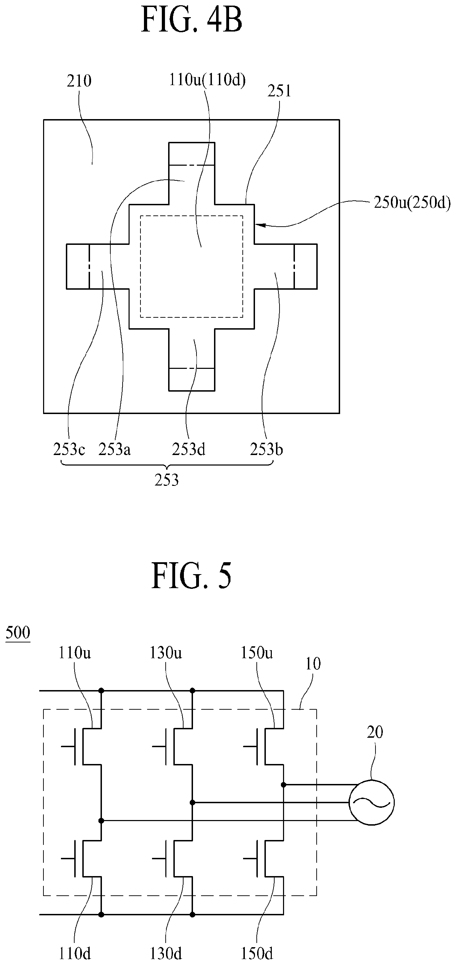

Hereinafter, various embodiments of the conductive clip shown in FIG. 1 will be described with reference to FIGS. 4A and 4B.

FIGS. 4A and 4B are plan views according to various embodiments of the conductive clip shown in FIG. 1. As shown in FIGS. 4A and 4B, the first and second conductive clips 250u and 250d may include a body portion 251 and a connection portion 253.

In the description of FIG. 4, for convenience of explanation, the reference numerals of the first semiconductor devices 110u, 130u, and 150u are indicated only as 110u, and the reference numerals of the second semiconductor devices 110d, 130d, and 150d are indicated only as 110d.

The body portion 251 covers the second surfaces of the first and second semiconductor devices 110u and 110d. The second surfaces of the first and second semiconductor devices 110u and 110d are surfaces facing the first and second heat dissipation substrates 230u and 230d. In this case, the body portion 251 may be physically or electrically coupled to the first and second semiconductor devices 110u and 110d.

The connection portion 253 may be configured to electrically connect the body portion 251 to the circuit board 210 and may include one or more branches. For example, the connection portion 253 may be constituted of two branches 253a and 253b as shown in FIG. 4A, or may be constituted of four branches 253a, 253b, 253c, and 253d as shown in FIG. 4B.

In one embodiment, the connection portion 253 may be implemented in the form of an inclined surface having a predetermined inclination, as shown in FIG. 1. When the connection portion 253 is provided in the form of an inclined surface, the molding member 270 may be formed into the space between the connection portion 253 and the first semiconductor devices 110u, 130u, and 150u so that electrical insulation between the first semiconductor devices 110u, 130u, and 150u adjacent to each other in the horizontal direction may be improved. In addition, the molding member 270 may be formed into the space between the connection portion 253 and the second semiconductor devices 110d, 130d, and 150d so that electrical insulation between the second semiconductor devices 110d, 130d, and 150d adjacent to each other in the horizontal direction may be improved.

According to the above-described embodiment, the drain electrodes formed on the second surfaces of the first and second semiconductor devices 110u and 110d are electrically connected to the circuit board 210 through the body portion 251 and the connection portion 253.

Referring again to FIG. 1, the first heat dissipation substrate 230u emits heat generated from the first semiconductor devices 110u, 130u, and 150u to the outside of the first heat dissipation substrate 230u, and the second heat dissipation substrate 230d emits heat generated from the second semiconductor devices 110d, 130d, and 150d to the outside of the second heat dissipation substrate 230d.

The first and second heat dissipation substrates 230u and 230d may include an insulating material layer 231, a metal wiring layer 233, and a heat dissipation metal layer 235.

The insulating material layer 231 electrically insulates the metal wiring layer 233 from the heat dissipation metal layer 235. The insulating material layer 231 may contain a ceramic material having high thermal conductivity.

The metal wiring layer 233 is formed on one surface of the insulating material layer 231 facing the circuit board 210. The metal wiring layer 233 may be patterned with a metal wiring. The drain electrodes formed on the second surfaces of the first semiconductor devices 110u, 130u, and 150u and the second semiconductor devices 110d to 150d may be directly connected to the metal wiring layer 233 through an adhesive member (not shown) or may be electrically connected to the metal wiring layer 233 via the conductive clips 250u and 250d. For example, the adhesive member may be a Sn-Ag-based adhesive member or an Ag-based adhesive member.

Although it has been described in FIG. 1 that the metal wiring is patterned on the metal wiring layer 233, in another embodiment, the metal wiring layer 233 may not be patterned. According to this embodiment, the metal wiring layer 233 may be attached to the conductive clips 250u and 250d in an un-patterned state through an insulating adhesive member.

As another example, in the case where the semiconductor module 100 according to one embodiment of the present disclosure does not include the first and second conductive clips 250u and 250d, the metal wiring layer 233 may be patterned when circuit connection through the metal wiring layer 233 is required. In this case, the metal wiring layer 233 may be attached to the first semiconductor devices 110u to 150u and the second semiconductor devices 110d to 150d through the conductive adhesive member.

The heat dissipation metal layer 235 is brought into contact with the insulating material layer 231 at one surface thereof and emits heat through the other surface thereof. A heat dissipation means including a cooling medium may be disposed adjacent to the other surface of the heat dissipation metal layer 235.

In the above-described embodiment, the metal wiring layer 233 and the heat dissipation metal layer 235 may be made of a copper-based metal. In view of the fact that the copper-based metal is attached, a substrate such as the first and second heat dissipation substrates 230u and 230d is called a direct bonded copper (DBC) substrate, an active metal brazing (AMB) substrate, or a direct plating copper (DPC) substrate.

In one embodiment, the molding member 270 may be formed in the space between the circuit board 210 and the first heat dissipation substrate 230u and the space between the circuit board 210 and the second heat dissipation substrate 230d. The molding member 270 may be an epoxy molding compound (EMC). The molding member 270 may increase an insulation distance between the circuit board 210 and the first and second heat dissipation substrates 230u and 230d, may protect the first and second semiconductor devices 110u to 150d from being affected by an oxidation, and may fix the first semiconductor devices 110u, 130u, and 150u and the second semiconductor devices 110d to 150d.

The molding member may also be positioned in the space between the connection portion 253 of the first and second conductive clips 250u and 250d and the first semiconductor devices 110u, 130u, and 150u and the second semiconductor devices 110d to 150d, and may also be positioned between the bumps 170u and 170d when the first semiconductor devices 110u, 130u, and 150u and the second semiconductor devices 110d to 150d include the bumps 170u and 170d.

A lead frame 290 may have one end connected to the circuit board 210 and the other end exposed to the outside. For example, one end of the lead frame 290 may be connected to the wiring of the circuit board connected to the electrodes of the first semiconductor devices 110u, 130u, and 150u and the second semiconductor devices 110d to 150d, and the other end thereof may be exposed to be electrically connected to an external load such as a motor, an input power source, or an inverter controller.

FIG. 2 is a diagram schematically showing the configuration of a semiconductor module having a double-sided heat dissipation structure according to a second embodiment of the present disclosure. As shown in FIG. 2, a semiconductor module 200 having a double-sided heat dissipation structure according to the second embodiment of the present disclosure includes first semiconductor devices 110u, 130u, and 150u, second semiconductor devices 1 10d, 130d, and 150d, a circuit board 210, a first conductive clip 250u, a second conductive clip 250d, a first heat dissipation substrate 230u, a second heat dissipation substrate 230d, and a molding member 270.

The semiconductor module 200 according to the second embodiment shown in FIG. 2 is the same as the semiconductor module 100 according to the first embodiment shown in FIG. 1 except that bumps 170u and 170d are not included. Therefore, hereinafter, only differences from the semiconductor module 100 including the double-sided substrate shown in FIG. 1 will be described.

In the case of the semiconductor module 200 according to the second embodiment, since the first semiconductor devices 110u, 130u, and 150u and the second semiconductor devices 110d to 150d do not include the bumps 170u and 170d, the electrode formed on the first surface of the first semiconductor devices 110u, 130u, and 150u is directly connected to a first circuit wiring (not shown) of the circuit board 210 through an adhesive member (not shown), and the electrode formed on the first surface of the second semiconductor devices 110d, 130d, and 150d is directly connected to a second circuit wiring (not shown) of the circuit board 210 through an adhesive member (not shown).

Meanwhile, in the same manner as in the semiconductor module 100 shown in FIG. 1, the metal wiring layer 233 of the semiconductor module 200 shown in FIG. 2 may not be patterned. According to this embodiment, the metal wiring layer 233 may be attached to the conductive clips 250u and 250d in an un-patterned state through an insulating adhesive member.

FIG. 3 is a diagram schematically showing the configuration of a semiconductor module having a double-sided heat dissipation structure according to a third embodiment of the present disclosure. As shown in FIG. 3, a semiconductor module 300 having a double-sided heat dissipation structure according to the third embodiment of the present disclosure includes first semiconductor devices 110u, 130u, and 150u, second semiconductor devices 1 10d, 130d, and 150d, a circuit board 210, a first bump 170u, a second bump 170d, a first heat dissipation substrate 230u, a second heat dissipation substrate 230d, and a molding member 270.

The semiconductor module 300 according to the third embodiment shown in FIG. 3 is the same as the semiconductor module 100 according to the first embodiment shown in FIG. 1 except that the semiconductor module 300 does not include the conductive clips 250u and 250d and the lead frame 290. Therefore, hereinafter, only differences from the semiconductor module 100 including the double-sided substrate shown in FIG. 1 will be described.

Since the semiconductor module 300 according to the third embodiment does not include the conductive clips 250u and 250d, a drain electrode formed on the second surface of the first semiconductor devices 110u, 130u, and 150u and the second semiconductor devices 110d to 150d, for example, the surface facing the heat dissipation substrates 230u and 230d may be directly electrically connected to the metal wiring layer 233 of the heat dissipation substrates 230u and 230d through a conductive adhesive member (not shown). Accordingly, the metal wiring layer 233 may be patterned to form a circuit wiring.

Meanwhile, in the case of the semiconductor module 300 illustrated in FIG. 3, since the lead frame is directly implemented using the circuit board 210, a separate lead frame is not required.

FIG. 5 is a schematic circuit diagram showing a power device to which the semiconductor module having a double-sided heat dissipation structure shown in FIGS. 1 to 3 is applied. As shown in FIG. 5, a power device 500 may include an inverter 10 and a motor 20.

The motor 20 provides power to an electric vehicle, a fuel cell vehicle, or the like. The motor 20 may be driven by receiving three-phase alternating current (AC) power.

The inverter 10 supplies AC power to the motor 20. The inverter 10 may receive direct current (DC) power from a battery or fuel cell, may convert the received DC power into AC power, and may then output the converted AC power to the motor 20.

The inverter 10 may include a plurality of semiconductor devices 110u, 110d, 130u, 130d, 150u, and 150d, and the semiconductor devices 110u, 110d, 130u, 130d, 150u, and 150d included in the inverter 10 may be packaged into one semiconductor module. According to this embodiment, the respective semiconductor devices 110u, 110d, 130u, 130d, 150u, and 150d shown in FIG. 5 may be mapped to the semiconductor devices 110u, 110d, 130u, 130d, 150u, and 150d shown in FIGS. 1 to 3, and the semiconductor modules 100, 200, and 300 according to an embodiment of the present disclosure shown in FIGS. 1 to 3 may perform the function of the inverter 10 of the power device 500.

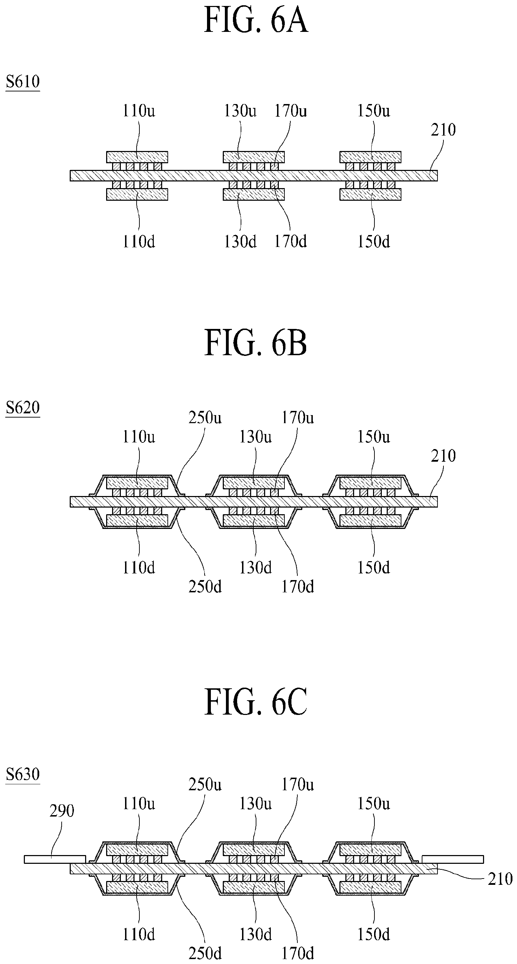

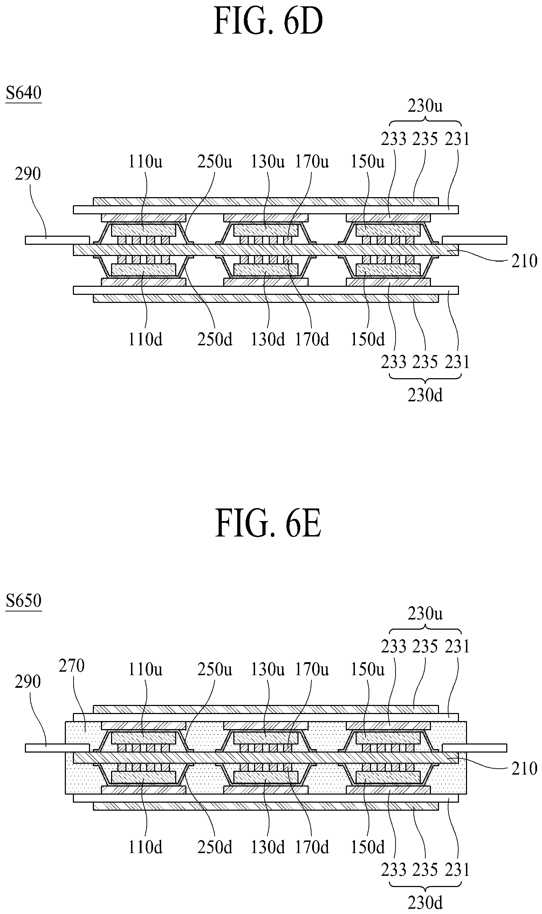

Hereinafter, a method for fabricating a semiconductor module having a double-sided heat dissipation structure according to the present disclosure will be described with reference to FIG. 6. FIGS. 6A to 6E are schematic process cross-sectional views showing a method for fabricating a semiconductor module having a double-sided heat dissipation structure according to one embodiment of the present disclosure.

First, as shown in FIG. 6A, in operation S610, the first semiconductor devices 110u, 130u, and 150u are mounted on the first surface of the circuit board 210 and the second semiconductor devices 110d, 130d, and 150d are mounted on the second surface of the circuit board 210. A first circuit wiring (not shown) is formed on the first surface of the circuit board 210, and a second circuit wiring (not shown) is formed on the second surface of the circuit board 210. The first semiconductor devices 110u, 130u, and 150u are mounted on the first surface of the circuit board 210 to be electrically connected to the first circuit wiring, and the second semiconductor devices 110d, 130d, and 150d are mounted on the second surface of the circuit board 210 to be electrically connected to the second circuit wiring.

At this time, a first electrode and a second electrode are formed on the first surface of the first semiconductor devices 110u, 130u, and 150u coupled to the first surface of the circuit board 210, and a third electrode is formed on the second surface of the first semiconductor devices 1 10u, 130u, and 150u. In addition, the first electrode and the second electrode are formed on the first surface of the second semiconductor devices 110d, 130d, and 150d coupled to the second surface of the circuit board 210, and the third electrode is formed on the second surface of the second semiconductor devices 110d, 130d, and 150d. For example, the first electrode may be a gate electrode, the second electrode may be a source electrode, and the third electrode may be a drain electrode. As another example, the first electrode may be a gate electrode, the second electrode may be an emitter electrode, and the third electrode may be a collector electrode.

In one embodiment, when the first semiconductor devices 110u, 130u, and 150u are mounted on the first surface of a predetermined region of the circuit board 210, the second semiconductor devices 110d, 130d, and 150d may be mounted on the second surface in the same region as the region on which the first semiconductor devices 110u, 130u, and 150u are mounted.

In this manner, in the present disclosure, the semiconductor devices 110u to 150d may be mounted on both surfaces of the circuit board 210 in a laminated form, so that the number of mountable semiconductor devices per process unit area increases, thereby reducing the area required to mount the same number of semiconductor devices.

In one embodiment, the first semiconductor devices 110u, 130u, and 150u and the second semiconductor devices 110d to 150d may be coupled to the circuit board 210 through the first and second bumps 170u and 170d. For example, by forming the first bump 170u between the first semiconductor devices 110u, 130u, 150u and the first surface of the circuit board 210, the first semiconductor devices 110u, 130u, and 150u are electrically connected to the circuit board 210 through the first bump 170u. In addition, by forming the second bump 170d between the second semiconductor devices 110d, 130d, and 150d and the second surface of the circuit board 210, the second semiconductor devices 110d, 130d, and 150d are electrically connected to the circuit board 210 through the second bump 170d.

In one embodiment, the first and second bumps 170u and 170d may be made of a copper-based metal. According to this embodiment, the first bump 170u and the second bump 170d may be formed through an electroless plating process, which is known to have relatively accurate thickness control.

For example, when the first semiconductor devices 110u, 130u, and 150u and the second semiconductor devices 110d to 150d are flip-chip type semiconductor device, the semiconductor module 100 may include a plurality of the first bumps 170u and a plurality of the second bumps 170d. In this case, the first and second electrodes of the first semiconductor devices 110u, 130u, and 150u and the second semiconductor devices 110d to 150d may be electrically connected to the circuit board 210 through the first and second bumps 170u and 170d formed on a semiconductor device pad portion (not shown) rather than a wire bonding method, so that fine pitch mounting may be possible.

In one embodiment, in order to improve the flatness of the semiconductor module 100, the first and second bumps 170u and 170d may be formed to have different thicknesses according to the thickness of the first and second semiconductor devices 110u to 150d connected to the corresponding bumps 170u or 170d and a distance between the first and second heat dissipation substrates 230u and 230d. That is, the bump connected to the thick semiconductor device among the first and second semiconductor devices 110u to 150d is formed to be thinner than the bump connected to the thin semiconductor device, or the bump connected to the thin semiconductor device may be formed to be thicker than the bump connected to the thick semiconductor device.

As described above, in the present disclosure, since the bumps 170u and 170d electrically connecting the semiconductor device to the circuit board 210 replace the existing spacer, the spacer can be removed, thereby preventing the occurrence of a crack due to the spacer. In addition, since the process of forming the spacer may be omitted, the manufacturing process of the semiconductor module can be simplified.

Meanwhile, when the bumps are not formed between the circuit board 210 and the first semiconductor devices 110u to 150u and between the circuit board 210 and the second semiconductor devices 110d to 150d, the first and second electrodes formed on the first surface of the first semiconductor devices 110u, 130u, and 150u and the second semiconductor devices 110d to 150d are directly electrically coupled to the circuit board 210 using a conductive adhesive member (not shown).

Next, as shown in FIG. 6B, in operation S620, the first conductive clip 250u is coupled to the circuit board 210 and the first semiconductor devices 110u, 130u, and 150u, and the second conductive clip 250d is coupled to the circuit board 210 and the second semiconductor devices 110d, 130d, and 150d. In one embodiment, the first conductive clip 250u is coupled to the second surface of the first semiconductor devices 110u, 130u, and 150u to cover at least a portion of the second surface of the first semiconductor devices 110u, 130u, and 150u, and the second conductive clip 250d is coupled to the second surface of the second semiconductor devices 110d, 130d, and 150d to cover at least a portion of the second surface of the second semiconductor devices 110d, 130d, and 150d.

Specifically, the body portion of the first conductive clip 250u is coupled to the second surface of the first semiconductor devices 110u, 130u, and 150u with a conductive adhesive member to be electrically connected to the drain electrode formed on the second surface of the first semiconductor devices 110u, 130u, and 150u, and the connection portion of the first conductive clip 250u is coupled to the first surface of the circuit board 210 with a conductive adhesive member. Through this, the drain electrode of the first semiconductor devices 110u, 130u, and 150u is electrically connected to the first circuit wiring of the circuit board 210.

Similarly, the body portion of the second conductive clip 250d is coupled to the second surface of the second semiconductor devices 110d, 130d, and 150d with a conductive adhesive member to be electrically connected to the drain electrode formed on the second surface of the second semiconductor devices 110d, 130d, and 150d, and the connection portion of the second conductive clip 250d is coupled to the second surface of the circuit board 210 with a conductive adhesive member. Through this, the drain electrode of the second semiconductor devices 110d, 130d, and 150d is electrically connected to the second circuit wiring of the circuit board 210.

Next, as shown in FIG. 6C, in operation S630, the lead frame 290, whose one end is exposed to the outside, is connected to the circuit board 210. For example, one end of the lead frame 290 may be connected to a wiring (not shown) of the circuit board 210 connected to the electrodes of the first semiconductor devices 110u, 130u, and 150u and the second semiconductor devices 110d to 150d, and the other end of the lead frame 290 may be exposed to be electrically connected to an external load such as a motor, an input power source, or an inverter controller.

Next, as shown in FIG. 6D, in operation S640, the first heat dissipation substrate 230u is coupled to the first conductive clip 250u, and the second heat dissipation substrate 230d is coupled to the second conductive clip 250d. In this case, in the first and second heat dissipation substrates 230u and 230d, the metal wiring layer 233 is patterned on one surface of the insulating material layer 231, and the heat dissipation metal layer 235 is formed on the other surface thereof.

According to this embodiment, the first heat dissipation substrate 230u is attached to the first conductive clip 250u using a conductive adhesive member (not shown) so that the metal wiring layer 233 of the first heat dissipation substrate 230u faces the first surface of the circuit board 210. In addition, the second heat dissipation substrate 230d is attached to the second conductive clip 250d using a conductive adhesive member so that the metal wiring layer 233 of the second heat dissipation substrate 230d faces the second surface of the circuit board 210. For example, the conductive adhesive member may be a Sn-Ag-based adhesive member or an Ag-based adhesive member.

In the above-described embodiment, the first and second heat dissipation substrates 230u and 230d may be formed through a method such as direct bonded copper (DBC), active brazing metal (AMB), or direct plating copper (DPC). The DBC method is a method in which a copper layer is formed on both surfaces of a ceramic substrate by a high-temperature oxidation process and the temperature is controlled in a nitrogen environment to bond copper with oxides used in the ceramic substrate. The AMB method is a method in which brazing is performed using an intermediate material between a ceramic substrate and a metal layer. The DPC method is a method in which copper plating is directly deposited on a ceramic substrate.

In the above-described embodiment, it has been described that the metal wiring layer 233 of the first and second heat dissipation substrates 230u and 230d is patterned, but when the circuit pattern of the metal wiring layer 233 for electrical connection of the first semiconductor devices 110u, 130u, and 150u and the second semiconductor devices 110d to 150d is not required, the metal wiring layer 233 may not be patterned. In this case, the metal wiring layer 233 may be coupled to the conductive clips 250u and 250d through an insulating adhesive member (not shown).

In the above-described embodiment, although it has been described that the conductive clips 250u and 250d are included, the conductive clips 250u and 250d may be optionally included. When the conductive clips 250u and 250d are not included, the process of coupling the conductive clips 250u and 250d to the first semiconductor devices 110u, 130u, and 150u and the second semiconductor devices 110d to 150d may be omitted. In this case, the metal wiring layer 233 of the first heat dissipation substrate 230u is directly coupled to the drain electrode of the first semiconductor devices 110u, 130u, and 150u through a conductive adhesive member, and the metal wiring layer 233 of the second heat dissipation substrate 230d is directly coupled to the drain electrode of the second semiconductor devices 110d, 130d, and 150d through a conductive adhesive member.

Next, as shown in FIG. 6E, in operation S650, the molding member 270 is formed in the space between the circuit board 210 and the first heat dissipation substrate 230u and the space between the circuit board 210 and the second heat dissipation substrate 230d. In one embodiment, the molding member 270 is formed by injecting an epoxy molding compound (EMC).

The molding member 270 may increase an insulation distance between the circuit board 210 and the first and second heat dissipation substrates 230u and 230d, may protect the first semiconductor devices 110u, 130u, and 150u and the second semiconductor devices 110d to 150d from being affected by an oxidation, and may fix the first semiconductor devices 110u, 130u, and 150u and the second semiconductor devices 110d to 150d.

In one embodiment, when the connection portion of the conductive clips 250u and 250d is provided in the form of an inclined surface, the molding member 270 may be formed in the space between the connection portion and the first semiconductor devices 110u, 130u, and 150u so that electrical insulation between the first semiconductor devices 110u, 130u, and 150u adjacent to each other in the horizontal direction may be improved. In addition, the molding member 270 may be formed in the space between the connection portion and the second semiconductor devices 110d, 130d, and 150d so that electrical insulation between the second semiconductor devices 110d, 130d, and 150d adjacent to each other in the horizontal direction may be improved.

In addition, when the first semiconductor devices 110u, 130u, and 150u and the second semiconductor devices 110d to 150d are a flip-chip type including a plurality of the bumps 170u and 170d, the molding member 270 may be formed even between the plurality of the bumps 170u and 170d.

Meanwhile, although FIG. 6 shows that operation S640 of coupling the lead frame 290 is included, the lead frame 290 may be directly implemented using the circuit board 210. In this case, the process of coupling the lead frame may 290 be omitted.

It may be understood that those skilled in the art may modify the present invention in other detailed forms without changing the technical spirit or the essential feature.

According to the present disclosure, since the semiconductor device can be implemented as a module type in which semiconductor devices are laminated via the circuit board, it is only necessary to bond the module type semiconductor devices between first and second heat dissipation substrates, whereby the fabricating process of the semiconductor module is simplified and the process control becomes easy.

In addition, according to the present disclosure, since the semiconductor devices are laminated on both surfaces of the circuit board, the number of mountable semiconductor devices per process unit area increases, thereby reducing the area required to mount the same number of semiconductor devices.

In addition, according to the present disclosure, the spacer may be removed because a bump electrically connecting the semiconductor device to the circuit board may replace the existing spacer, whereby it is possible to prevent the occurrence of a crack due to the spacer and omit the process of forming the spacer, thereby simplifying the fabricating process of the semiconductor module.

In addition, according to the present disclosure, by mounting the semiconductor device on the circuit board using the bump formed on the semiconductor device, a fine pitch is possible, thereby enabling a fine assembly process.

In addition, according to the present disclosure, the first and second electrodes formed on the first surface of the semiconductor device may be electrically connected to the circuit board through the bump, and a third electrode formed on the second surface of the semiconductor device may be electrically connected to the circuit board using a conductive clip coupled to the second surface in surface contact, whereby electrical connection and heat dissipation are possible through the conductive clip, maximizing heat dissipation performance.

Therefore, the above-described embodiments should be understood to be exemplary and not limiting in every aspect. The scope of the present disclosure will be defined by the following claims rather than the above-detailed description, and all changes and modifications derived from the meaning and the scope of the claims and equivalents thereof should be understood as being included in the scope of the present disclosure.

## Claims

1. A semiconductor module comprising:
a circuit board having a first surface and a second surface;
a first semiconductor device, the first semiconductor device being mounted on the first surface of the circuit board;
a second semiconductor device, the second semiconductor device being mounted on the second surface of the circuit board;
a first heat dissipation substrate, the first heat dissipation substrate being placed on the top of the first semiconductor device, wherein the first heat dissipation substrate is coupled to a second surface of the first semiconductor device with a second electrode formed thereon; and
a second heat dissipation substrate, the second heat dissipation substrate being placed on the top of the second semiconductor device, wherein the second heat dissipation substrate is coupled to a second surface of the second semiconductor device with a second electrode formed thereon.

2. The semiconductor module of claim 1, further comprising:
a conductive clip, the conductive clip being mounted on the circuit board, either between the first semiconductor device and the first heat dissipation substrate to cover the surface of the first semiconductor device and to support the first heat dissipation substrate or between the second semiconductor device and the second heat dissipation substrate to cover the surface of the second semiconductor device and to support the second heat dissipation substrate.

3. The semiconductor module of claim 1 or 2, wherein the semiconductor module further comprises at least one or more of the first semiconductor devices and at least one or more of the second semiconductor devices.

4. The semiconductor module of any one of claims 1 to 3, wherein the first semiconductor device and the second semiconductor device, each comprises at least one or more of bumps, and,
wherein the thickness of each of the bumps is determined according to the thickness of the first semiconductor device or the second semiconductor device to which each of the bumps is connected.

5. The semiconductor module of any one of claims 1 to 4, wherein the first semiconductor device includes a first bump disposed between a first surface of the first semiconductor device and the first surface of the circuit board to electrically connect a first electrode of the first semiconductor device to the circuit board, and
wherein the second semiconductor device includes a second bump disposed between a first surface of the second semiconductor device and the second surface of the circuit board to electrically connect a first electrode of the second semiconductor device to the circuit board.

6. The semiconductor module of any one of claims 2 to 5, wherein the conductive clip at least partially covers the top of the first semiconductor device or the top of the second semiconductor device.

7. The semiconductor module of any one of claims 2 to 6, wherein an electrode of the first semiconductor device or the second semiconductor device is electrically connected to the circuit board through the conductive clip, and
wherein the electrode comprises a gate electrode, a source electrode electrically isolated from the gate electrode, and a drain electrode.

8. The semiconductor module of any one of claims 5 to 7, wherein a set of the first heat dissipation substrate, the conductive clip, the first semiconductor device, and a first bump and a set of the second heat dissipation substrate, the conductive clip, the second semiconductor device, and a second bump are structured symmetrically with respect to the circuit board.

9. The semiconductor module of any one of claims 2 to 8, further comprising:
a molding member to hold the conductive clip, wherein the molding member is formed in a space between the circuit board and the first heat dissipation substrate or a space between the circuit board and the second heat dissipation substrate.

10. The semiconductor module of claim 9, wherein the conductive clip includes a connection portion having an inclined surface, and
wherein the molding member is formed in a space between the first semiconductor device and the inclined surface and a space between the second semiconductor device and the inclined surface.

11. A method for fabricating a semiconductor module comprising:
placing a circuit board having a first surface and a second surface;
mounting a first semiconductor device on the first surface of the circuit board;
mounting a second semiconductor device on the second surface of the circuit board;
placing a first heat dissipation substrate on the top of the first semiconductor device, wherein the first heat dissipation substrate is coupled to a second surface of the first semiconductor device with a second electrode formed thereon; and
placing a second heat dissipation substrate on the top of the second semiconductor device, wherein the second heat dissipation substrate is coupled to a second surface of the second semiconductor device with a second electrode formed thereon.

12. The method of claim 11, further comprising:
mounting a first conductive clip on the circuit board between the first semiconductor device and the first heat dissipation substrate to cover the surface of the first semiconductor device and to support the first heat dissipation substrate; and
mounting a second conductive clip on the circuit board between the second semiconductor device and the second heat dissipation substrate to cover the surface of the second semiconductor device and to support the second heat dissipation substrate,
wherein the first conductive clip and the second conductive clip, each at least partially covers the top of the first semiconductor device and the top of the second semiconductor device, respectively, and
wherein the first and second conductive clips include a plurality of connection portions having an inclined surface.

13. The method of claim 12, further comprising:
forming a molding member to hold the conductive clip in a space between the circuit board and the first heat dissipation substrate and a space between the circuit board and the second heat dissipation substrate,
wherein the forming of the molding member includes forming the molding member in a space between the first semiconductor device and the inclined surface and a space between the second semiconductor device and the inclined surface.

14. The method of claim 13, further comprising, before the forming of the molding member:
connecting a conductive frame having one end connected to the circuit board and the other end opened toward the outside of the semiconductor module,
wherein a set of the first heat dissipation substrate, the first conductive clip, and the first semiconductor device and a set of the second heat dissipation substrate, the second conductive clip, and the second semiconductor device are structured symmetrically with respect to the circuit board.

15. The method of any one of claims 11 to 14, further comprising:
forming one or more bumps to connect with the first semiconductor device and the second semiconductor device.
